Europäisches Patentamt

European Patent Office

Office européen des brevets

(11) Publication number: **0 047 382**
**A2**

# EUROPEAN PATENT APPLICATION

(21) Application number: **81105735.5**

(22) Date of filing: **21.07.81**

(51) Int. Cl.³: **G 06 F 5/00**

(30) Priority: **05.09.80 US 184595**

(43) Date of publication of application: **17.03.82**
**Bulletin 82/11**

(84) Designated Contracting States: **DE FR GB IT**

(71) Applicant: **International Business Machines Corporation, Armonk, N.Y. 10504 (US)**

(72) Inventor: **Goertzel, Gerald, 7 Sparrow Circle, White Plains New York 10605 (US)**

(74) Representative: **Lancaster, James Donald, IBM United Kingdom Patent Operations Hursley Park, Winchester Hants S021 2JN (GB)**

(54) **Adaptive compression encoding of a binary-source symbol string.**

(57) This invention relates to a technique for appending prefixed code words to a code word stream conditioned by each least probable symbol in a binary source symbol string. The generation of the prefixed code word from a bounded code word space is managed dynamically by a memory (9) requiring only space availability measures (47, 51) at the start and end of the encoding cycle as input thereto. The memory delivers the prefixed code word of an appropriate derived length to output devices (7) for further processing. The encoder (2), responsive to each input triplet of symbol, symbol estimate, and probability of occurrence measure, generates the space availability measures PC(i) and PC(i-I), and modifies the memory contents so as to reduce the remaining code space. This reduction reflects the fact that the particular code word delivered has been used up and cannot be the prefix of any future delivered code word. The length of each code word requested is composed of two components. The first is the «run» of most probable symbols component, and the second is the terminating least probable symbol component. When the code word length requested exceeds the capacity of the memory to deliver, then the code word length is decreased to the maximum permissible. When the code word space is used up, the memory is considered overflowed and results in a reset in which the code capacity is reinitialized.

ENCODER BLOCK DIAGRAM

- 1 -

METHOD FOR THE ADAPTIVE COMPRESSION ENCODING OF A
BINARY SOURCE SYMBOL STRING, METHOD FOR APPENDING PREFIXED
CODE WORDS TO A CODE WORD STREAM, AND METHOD FOR
GENERATING VARIABLE LENGTH PREFIXED CODE WORDS.

## Technical Field

This invention relates to the efficient assignment of code words
exhibiting the prefix property in order to achieve data compression
approaching the ideal. More particularly, the invention is applicable
to a method for compression coding, where prefix code words can be
assigned on a binary-source-symbol-by-binary-source-symbol basis where
the statistical characteristics of the source string may vary.

## Background

A binary data source emits the symbols 0 and 1 in the form of
variable length runs of consecutive 0's and 1's. One statistical
characterization of such a binary source is in terms of ascertaining
whether a "0" is more probable, or whether a "1" is more probable. In
this regard, a run is considered as consisting of 0 or more occurrences
of consecutive more probable symbols (MPS) followed by a single occurrence
of a less probable symbol (LPS). In order to increase the source
alphabet, some form of symbol blocking is used. This larger alphabet is
then encoded with a prefix code, conforming to the new probability
distribution from which the new symbols are assumed to be drawn. The
run-length alphabet consists of symbols, for example, corresponding to
groupings $\_,0,00,000,\ldots,00\ldots0$, etc. These can be assigned to represent
length of binary source symbol strings of 1, 2, 3, 4, ..., j, bits
respectively. In this regard, length j may be considered as the run-
length symbol index.

YO979089

2

Consideration should be given to the source probability distribution upon which run-length codes are based. Suppose the probability of the more probable symbol p(MPS) is stationary and independent, i.e. there is no intersymbol influence, then the probability of each symbol in the run length alphabet could be determined as follows:

$$p(run\ i) = [p(MPS)]^{i-1} * p(LPS)$$

Upon this assumption of a stationary and independent occurrence of symbols, Golomb designed an appropriate compact code. This was described in his letter on "Run Length Encodings", IEEE Transactions on Information Theory, 1966, pages 399-401. Golomb proposed a model of the symbol source in which the frequencies of occurrence of the two symbols 0 and 1 were invoked. Using the notations LPS and MPS, Golomb's starting premise was that $p(LPS) + p(MPS) = 1$. From these values, Golomb invoked an integer parameter m such that $[p(MPS)]^m = 1/2$. For each value of m, Golomb then devised a run-length code word.

In black and white image encoding, each instance of a symbol is called a picture element (PEL), and assumes either the value of 0 or 1. Images can be thought of as raster scannable arrays of 1's and 0's. Experience has demonstrated that the probability of a PEL is correlated to the values of neighboring PEL's. In that neighborhood, a portion of previously encoded PEL values can be set to define a Markov state which can be used as a basis for encoding the value of a current PEL. In turn, the decoder successively decodes each PEL, and once decoded,

YO979089

3

the value of the last PEL becomes part of the conditioning state for the next PEL. In the encoding and decoding procedures, this type of Markov conditioning is performed PEL by PEL. The model of such a source may be termed a bit-wise Markov model. It is thus apparent that Golomb's code, in which the source was characterized as being constant, is not suitable for such a bit-wise Markov model.

It is also appreciated in the art that the minimum code word length (minimum number of bits) which can be used to represent a counterpart source message is a function of the logarithm of the inverse probability symbol of occurrence. Illustratively, a 30-bit message,

"...000010000000000110000000000001..."

requires no more than $4 \log_2 (1/.1) + 26 \log_2 (1/.9) = 17.24$ bits where $p(0) = 0.9$ and $p(1) = 0.1$ and minimum message length $= \Sigma \log_2 [1/p(n)]$ and $p(n) = $ probability of bit n.

Since the source symbol strings are characterized as runs of MPS's and terminated by an LPS, then an ideal length measure $\ell'$ could be expressed as:

$\ell'$(run i of MPS's) $= \log_2 [1/[[p(MPS)]^{i-1} * p(LPS)]] = (i-1) * \ell'(MPS) + \ell'(LPS)$. On this basis, the runs, code words and lengths for a Golomb code for m = 2 are shown in Table 1.

| Run | Code Word | Ideal Length | Integer Length Approximation | m = 2 |
|---|---|---|---|---|
| | | 1 | 1 | |
| 1 | 00 | 1.77 | 2 | |
| 01 | 01 | 2.27 | 2 | |
| 001 | 100 | 2.78 | 3 | |
| 0001 | 101 | 3.26 | 3 | |
| 00001 | 1100 | 3.78 | 4 | |
| 000001 | 1101 | 4.29 | 4 | |

Table 1

Suppose that the assumption of the binary source probability distribution for each PEL is changed so as to depend on the number of preceding MPS's in the source symbol string. In this regard, any model of the source symbol uses the past history of the string for conditioning purposes. It follows that a modified Huffman code can be designed to the case where the probability $p_i$(MPS) is a function of its position i from the beginning of the run. It should be noted that this is still not a completely nonstationary source, because there is only one Huffman code for all runs in the image to be encoded. Any modified Huffman code is limited to a model which allows for PEL-wise conditioning of each PEL only insofar as the LPS/MPS determination is ascertained. However, after the code is designed, the distribution for the ith symbol from the beginning cannot be changed.

The prior art has further recognized that the problem of obtaining good data compression may be separated into two parts. These are (1) the creation of a probability model of the data source, and (2) the encoding of the data using the model for selecting compression efficient code words. Such a partition between model and encoder was described with reference to arithmetic coding by G. G. Langdon, Jr., and Jorma Rissanen in co-pending European patent application, publication No. 29967. In that reference, the state conditioning element shown in Fig. 1 is the model driving the binary encoding element. Lastly, both Golomb and Langdon, et al, references disclose the appending or combining of a code word to a code word stream conditioned upon the occurrence of each least probable symbol in the binary source symbol string.

## The Invention

It is accordingly one object of this invention to devise a method          for compression coding where prefix code words can be assigned on a binary-symbol-by-binary-symbol basis, and where the statistical characteristics of the string may vary.  It is a further object to devise a method          for appending prefixed code words to a code word string conditioned by each least probable symbol in a binary source symbol string.  The method so devised should be implementable upon encoders of the type independent and distinct from the stochastic models of the binary symbol sources serving as one of several inputs to the encoder.

It was unexpectedly observed that the foregoing objects could be satisfied by the following steps responsive to each source symbol.  These steps, respectively, are those of (1) deriving an integer valued approximation of the code word length from the model as required for run-length index i of the most probable source symbols; (2) dynamically generating a prefixed code word of the derived length from a bounded code word space; and (3) reducing the code space available for the next code word generating cycle by an amount proportional to all code words having the same prefix.  The code space is reset to a predetermined reference value in the event that either the source symbol being encoded is a least probable symbol (LPS) or that the space remaining is less than the derived code word length.

The method of the invention may be embodied in an apparatus comprising a source model, an encoder, and the necessary assembly, buffering and data transmission elements. The source model is responsive to each symbol and generates an estimated symbol and an associated probability of occurrence measure.  The encoder accepts as input, during each encoding cycle, the symbol, the estimate, and the probability measures. The encoder, in turn, generates in response to this input triplet a code word and an indication of whether the applied symbol was MPS or LPS. An appropriate transmission gating arrangement appends the code word, i.e. sends it out, only if there is an LPS indication.

The dynamic generation of the prefix code word from a bounded code word space is managed by a memory requiring only space availability measures at the start and end of the encoding cycle as input thereto. The memory delivers the prefixed code word of an appropriate derived or requested length. The encoder modifies the memory contents so as to reduce the code space available. This reflects the fact that the particular code word delivered has been used up and cannot be the prefix of any future delivered code word.

Significantly, the length of each code word requested is composed of two components. The first is the "run" component, and the second is the terminating LPS component. The longer the run of MPS's, then the longer the requested code word length. If the requested code word length is greater than some selected maximum, then it is reduced to the selected maximum. When the code word space is used up, then the last code word is transmitted. This is followed by 1 bit indicative of whether the PEL was LPS or MPS. At this point, the code capacity is reinitialized to unity.

Advantageously, use of this invention results in the compression of runs of 1's and 0's to within an integer-valued approximation of the theoretical compression minimum. Further, binary symbols may be encoded according to their own conditional probability. This is an extension of run-length encoding to binary sources whose statistics are not stationary. This invention stands in marked contrast to an integer length arithmetic code described by Langdon, et al, in IBM Technical Disclosure Bulletin, Vol. 22, No. 10, March, 1980, pages 4688-4689, in which an arithmetic code was invoked.

Brief Description of the Drawing

Fig. 1 depicts a general block diagram of the binary-source-symbol-to-code-word-appending and code-word-stream-to-binary-symbol transformation apparatus, using dynamic code word assignment.

Fig. 2 depicts an encoder block diagram, including a calculator, memory and transmission elements. These elements are respectively represented in detailed logic in Figs. 3, 7 and 6.

Figs. 4 and 5 reference the limiter and decrementer components of the calculator shown in Fig. 3. The limiter maintains an upper bound on the length requested, while the decrementer tracks the remaining code space in the memory as seen in Fig. 7.

Fig. 8 shows an example of consecutive code words of different lengths mapped onto a line segment of unity length.

Fig. 9 shows a typical set of code words generated responsive to a symbol stream according to the invention.

Description of the Preferred Embodiment
and Industrial Applicability

In order to appreciate the invention, a conceptual description of the dynamic code assignment is set forth to aid understanding of the preferred embodiment. It must be understood that the bit-wide Markov model assumes a probability distribution from which each source symbol bit value is taken into account. Assume that the maximum length code word is 16 bits in length. Then code word generation could be envisioned in the form of a binary encoding tree of depth 16. Encoding, then, can be conceptually decomposed into two functions, that of a length requester and a dynamic code word provider. The requester requests of the code word provider a prefixed code word of length $\ell_R$. The code word provider generates a code word, modifies its internal state so as to indicate that the code word delivered has been used up and cannot be a prefix of any other future delivered code word. In this sense, let K denote the portion of the "tree" or code space used up following the ith request. Thus,

$$K = \sum_{j=1}^{i} 2^{-\ell_R(j)}$$

in which $\ell_{R(j)}$ denotes the length requested in response to the jth symbol in a run. The sum on the right-hand side of this relation is termed the Kraft sum. After the code word generating source or the available code space has been reset, then K = 1.

Let $p_j$(LPS) and $p_j$(MPS) denote the probability distribution for the jth binary source symbol. Also, let PC(i) denote the portion of the code space available. Thus, where i = 0, then PC(0) = 1. It follows that the code space generally available at the end of the i-1 code cycle in a run with respect to the ith run is governed by

$$PC(i-1) = 1 - \sum_{j=1}^{i-1} 2^{-\ell_R(j)}.$$

For the ith symbol, the ith length request $\ell_{R(i)}$ is governed according to the relation

$$\ell_{R(i)} = \log_2 \lfloor 1/2 + 1/PC(i-1) * p_i(LPS) \rfloor, \text{ where}$$

$\lfloor .. \rfloor$ denotes the least integer. This implies that a rounding operation is necessary in order to obtain an integer value for $\ell_{R(i)}$.

If the ith symbol to be encoded is LPS, then "ideal" length contribution to the code word for the run is $\log_2(1/p_i(LPS))$. This is, however, only one component of the two components ideal code word length. Furthermore, the product $PC(i-1)*p_i(LPS)$ represents the portion of $p_i(LPS)$ of the code space which remains. This means that the Kraft sum has already been taken up by the previous MPS symbols in the run.

Significantly, any length request $\ell_{R(i)}$ can be conceptualized as being formed from two components. The first is the component formed from the run of MPS symbols, while the second is obtained from the terminating LPS component $\ell_i(LPS)$.

If the ith symbol in a run is LPS, then the generated code word is appended to the outgoing code word stream. Concurrently, the code space represented by PC is reinitialized to "1". If the ith symbol is MPS, then only the available code space is altered. In particular the code space is diminished by an amount proportional to all code words having the same prefix. The generated code word is not appended to the output code word stream. The magnitude of remaining code capacity is adjusted according to the following relation

$$PC(i) = PC(i-1) - 2^{-\ell_{R(i)}}.$$

As the lengths requested increase has a function of an ever increasing run of MPS's, the condition arises where the length requested exceeds the available code space. In this invention, this condition is managed by reducing the requested length to a fixed upper limit of bits, say 16. The code space for this requested length is used up. Eventually it may happen that the available code space, PC, may become exhausted. If this occurs, then a counterpart code word is sent irrespective of whether the symbol was LPS or MPS. The symbol value is accounted for by the appending of an additional bit to the code word stream, i.e., "0" for MPS, and "1" for LPS.

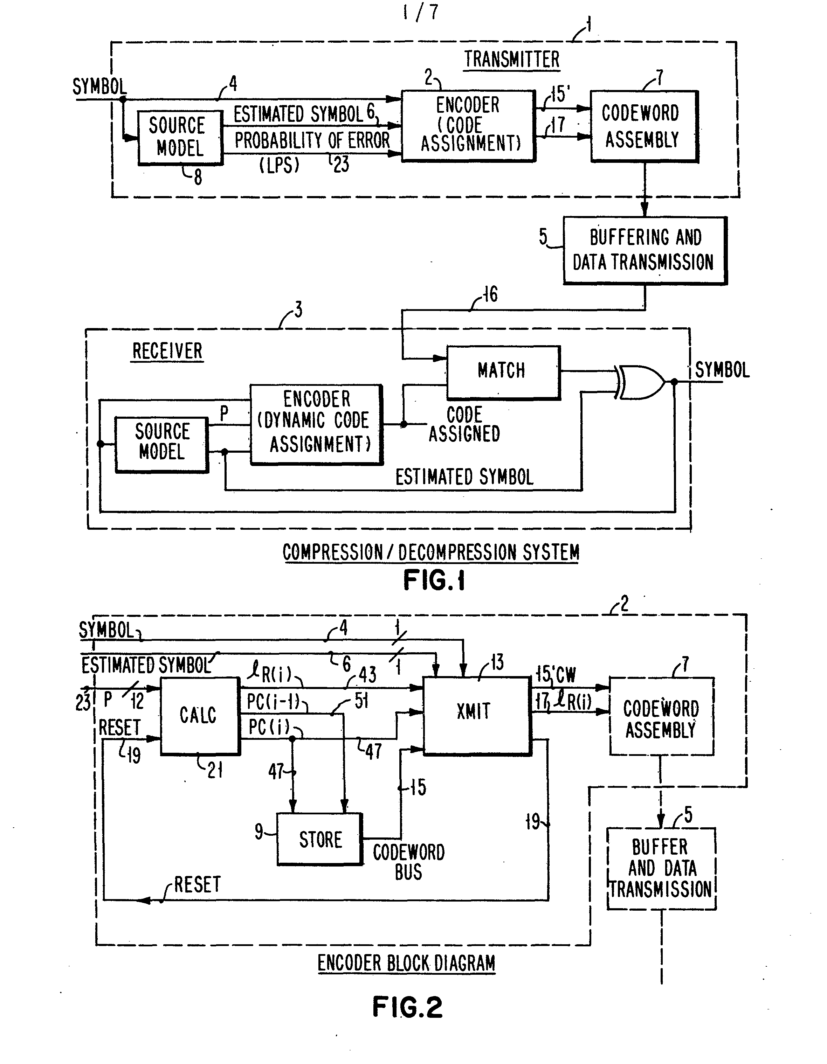

Referring now to Fig. 1, there is depicted a general block diagram of the binary-source-symbol-to-code-word-appending and code-word-stream-to-binary-symbol transformation apparatus using dynamic code word assignment. A series of binary symbols, i.e., 1's and 0's, are applied on path 4 to the transmitter 1. A stream of code words may be outputted from the transmitter through a suitable assembly device 7 and transmitted over path 16 to a remote receiver 3. The assembly of code words and the line signal conditioning and other data transmission concerns are not fully described herein. Reference can be made to any standard work, such as Davies and Barber, "Communication Networks for Computers", John Wiley and Son, 1973, for the design of suitable information transmission links and protocols.

Transmitter 1 operates upon successive symbols applied at input 4 during successive encoding or clock cycles. During each clock cycle, a symbol is simultaneously applied to an encoder 2 and a source model 8. Since one aspect of

11

this invention concerns the method of code word assignment to successive input symbols, a description of the design and implementation of a source model is also believed outside the scope of the specification. Reference can be made to the co-pending Langdon, et al, application for a recitation of the general input, output and finite state machine factors involved in source modeling design.

The encoder 2 accepts an input symbol on path 4, an estimated symbol on path 6, and a probability measure of LPS on path 23 from source model 8. For the binary case, both the symbol and the estimated symbol are each 1 bit. The probability of occurrence measure of LPS is, in this embodiment, implemented as a 12-bit binary fraction lying in the range between the 0 and 1/2. In turn, the encoder outputs are transmitted over paths 15' and 17 to code word assembly 7. In this regard, the output on path 15' consists of a code word of up to 12 significant bits, together with an indication that the source symbol was MPS or LPS. The output on path 17 is a 4-bit-wide length attribute $\ell_{R(i)}$ indicative of the code word length counted from most-to-least-bit significance. Relatedly, it should be understood that the receiver is the dual of the transmitter and includes a source model and an encoding element which tracks the encoder actions. In view of this, attention is properly focused on the transmitter 1 in order to obtain a full and complete appreciation of the nature and scope of the invention.

Referring now to Fig. 2, there is shown an encoder block diagram. The major encoder components consist of a calculating element 21, a transmitting element 13, and a store element 9. The symbol probability measure P is

12

applied to calculator 21 over the 12-bit-wide path 23. The 1-bit-wide symbol and estimated symbol are respectively sent to transmitter 13 over counterpart bit paths 4 and 6. The output of calculator 21 consists of the length attribute $\ell_{R(i)}$ and is sent via a 4-bit-wide path 43 to transmitter 13. The other calculator 21 output to transmitter 13 is PC(i) sent over 12-bit-wide path 47. This output is likewise applied to store 9. The remaining calculator output PC(i-1) is applied only to store 9 over the 12-bit-wide path 51.

Store 9, which provides the variable length code words to transmitter 13 over the 12-bit-wide bus 15, is driven only by PC(i), PC(i-1) on respective paths 51 and 47.

Transmitter 13 is the major choice box for the encoder. Here both the symbol and estimated symbol terminate respectively over 1-bit-wide paths 4 and 6. Further, the length request or attribute $\ell_{R(i)}$ and the fractional available code space for the next cycle PC(i), as well as the code word, all terminate over paths 43, 47 and 15. In the event that the symbol differs from the estimated symbol (as they occur on paths 4 and 6), then the transmitter 13 will send the code word and $\ell_{R(i)}$ for appending to the code word string over respective paths 15' and 17. As has been previously mentioned, the code space is reset in the event of an LPS or when the available code space is used up. This reset is sent from transmitter 13 to calculator 21 and to code word assembly 7 over the 1-bit-wide path 19.

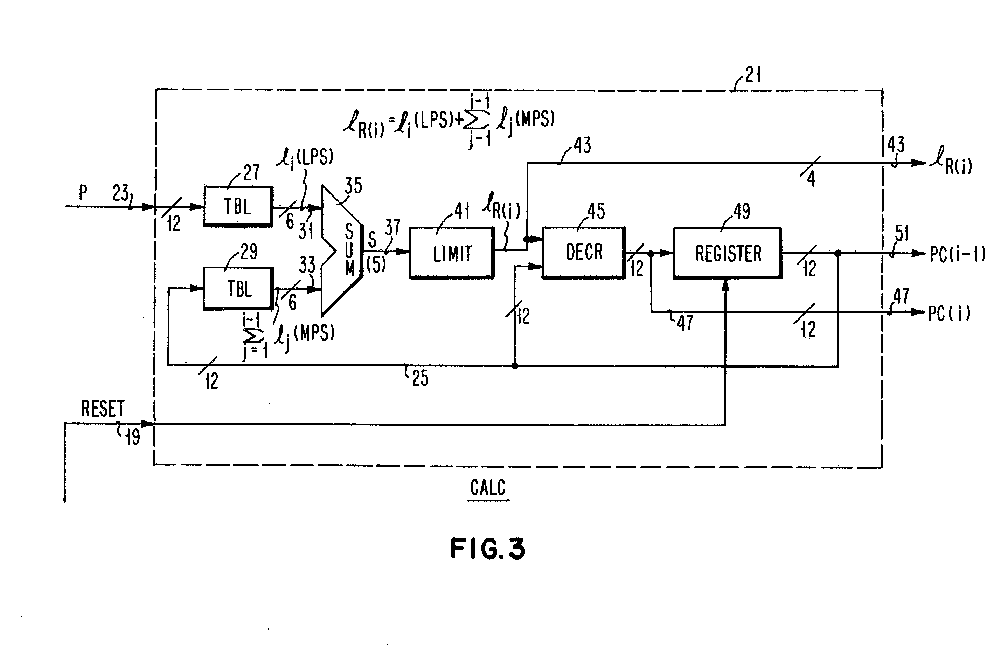

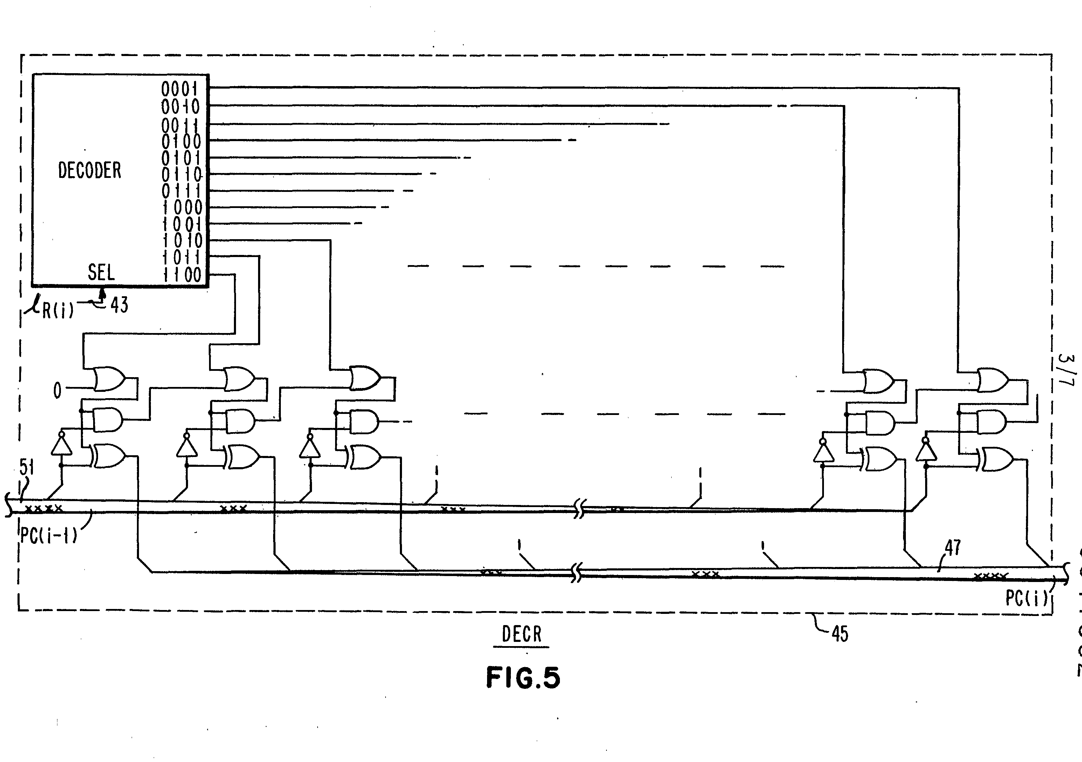

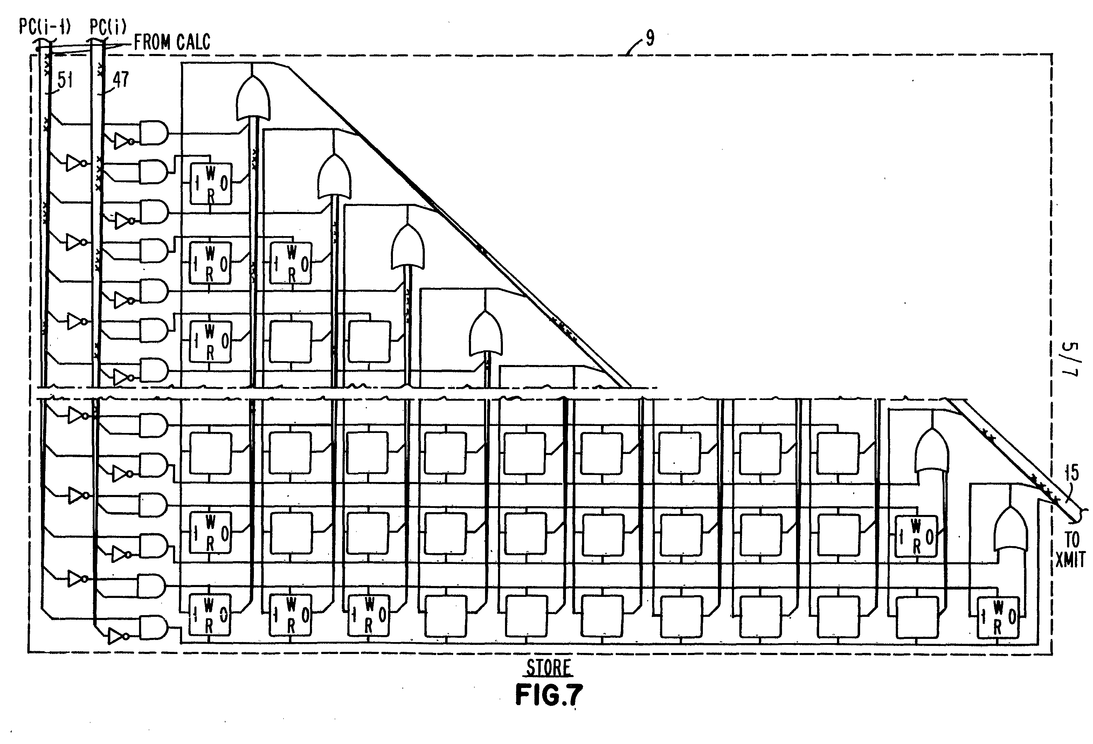

It should be recalled that the method concerns obtaining the output from the input in such a manner that the compressed messages are, on the average, nearly as short as the theoretical minimum. In this regard, the encoder 2 consists of combinatorial elements with two sets of storage elements to remember the state from one coding cycle to the next. The state is always initialized after a reset. The storage elements just mentioned are a register 49 (Fig. 3) which saves the value of PC(i-1) and a multiple-bit addressable memory store 9. Store 9 remembers the next unused code word for each of the possible lengths. PC(i-1) is represented as a 12-bit binary fraction of the unused code space at the beginning of the present cycle. Store 9 in Fig. 7 is depicted as containing 66 bits of storage elements organized into 11 groups of varying lengths. Each such group is associated with a code one longer than the number of bits in the group.

Calculator 21 shown in Fig. 3 has as its input the probability of occurrence of the LPS, p(LPS), on path 23 and has as its output $\ell_{R(i)}$, PC(i) and PC(i-1) on respective paths 43, 51, and 47. The output PC(i-1) is sent back over path 25 for accessing a table stored in memory 29 and to control the operation of decrementer 45. The probability on path 23 is likewise applied to a table stored in memory 27. The contents of the tables in memories 27 and 29 are the same. The memories' output circuits drive respective 6-bit-wide paths 31 and 33 to input of summation circuit 35. The summation output is applied over the 5-bit-wide path 37 to limiter 41.

The available code space signal PC(i-1) is applied to memory 29 for accessing that component of the length request due to the run of MPS symbols, i.e.,

$$\sum_{j=1}^{i-1} \ell_j(MPS).$$

Similarly, the probability measure P is used to access memory 27 to obtain the length due to the terminating LPS

14

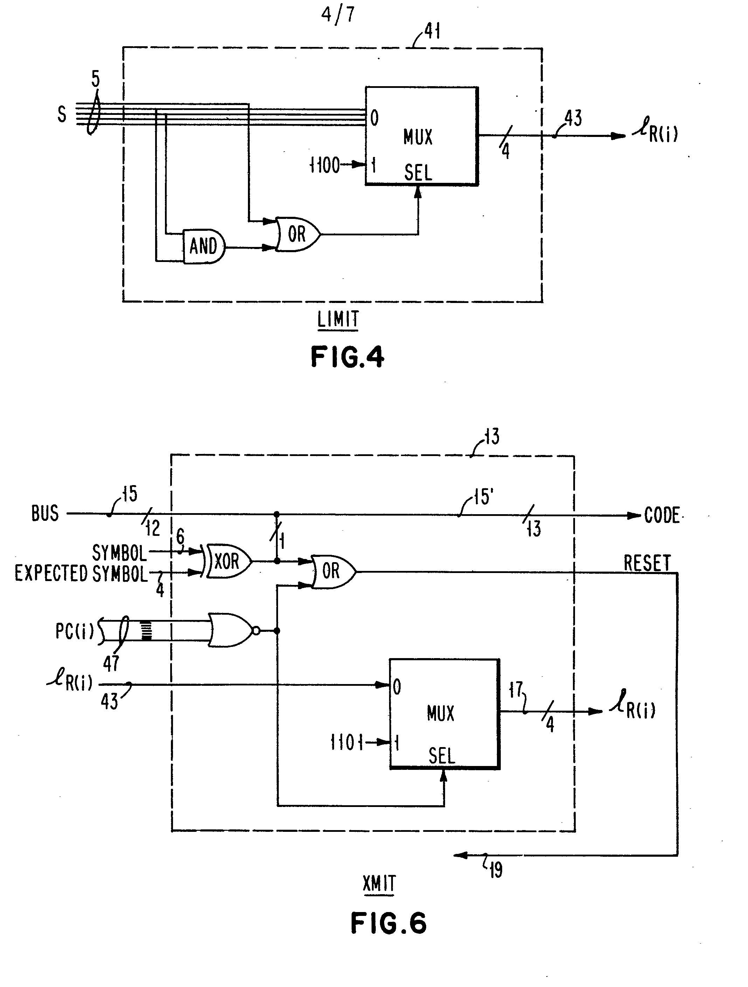

component $\ell_i$ (LPS). Parenthetically, memories 27 and 29 may be preferably implemented as programmed logic arrays (PLA's) to minimize size. It should be noted that the length components are summed in accumulator 35. Their output is applied to limiter 41. In order to avoid overflow, length requests exceeding a predetermined magnitude, say 12, are forced to 12. This is implemented by the logic in Fig. 4 where combinational logic and a multiplexer responsive to the binary number $S \geq 12$ forces the value 12 onto line 43. The combined length request $\ell_{R(i)}$ from the limiter is, in turn, applied as an input to decrementer 45 and is an output to transmitter element 13 over 4-bit-wide path 43.

Decrementer 45 depicted in Fig. 5 is an ordinary subtractor and compares the available code space PC(i) with the length request $\ell_{R(i)}$ in decrementer 45. The length request $\ell_{R(i)}$ is applied to a decoder which translates the length to the fractional value $2^{-\ell}R(i)$. This is necessary in view of the fact that the available code space is represented as such fractional values. As a consequence, the difference forms the value PC(i) and is applied to register 49 over a connecting 12-bit-wide path. In summary, calculator 21 is independent of either the symbol or the estimated symbol. It determines what length code word will be obtained from store 9.

Referring now to Fig. 7, when taken together with Fig. 1, there is shown a detailed logic diagram of store 9. The store uses the values of PC(i) and PC(i-1) to determine from its internal contents the code word to be sent to transmitter element 31. A code word so selected is applied on bus 15. The store 9 facilitates the altering of its

15

internal contents so as to be ready for the next encoding
cycle. If PC(i-1) = 000000000000, then the subsequent
sequence of code words is independent of a contents of
store 9 prior to this cycle. It should be observed
that the store is configured with 66 cells. These are
arranged in an 11 x 11 half matrix. With conventional
combinational logic, the row and column inputs formed by
predetermined conductors from the 12-bit-wide path 51 and
12-bit-wide path 47 provide the access path connections
to the cells. A description of the dynamics of store
operation is deferred to the description of an illustrative example.

Referring now to Fig. 6, there is shown a detailed
logic diagram of transmitting element 13. Here, the code
word upon the 12-bit-wide bus 15 is received. Where the
expected symbol is most probable, the output of an attendant XOR circuit is 0, otherwise 1, and is placed upon a
bit-wide path forming part of path 15'. The 13-bit-wide
path 15' terminates in assembler 7. The reset signal on
line 19 indicates to the code word assembly that a code
word is to be sent. This code word will have a length
of at most 12 bits unless PC(2)=0000 0000 0000. In this
case, 13 bits are transmitted. The first twelve bits
consist of the code word, while the thirteenth bit is the
value on the extra bit line. A multiplexor device driving
line 17 sends either the data from path 43 or 1101 (13), as
appropriate. The bit value upon the extra bit line is
indicative as to whether the code word was responsive to
an LPS or MPS symbol.

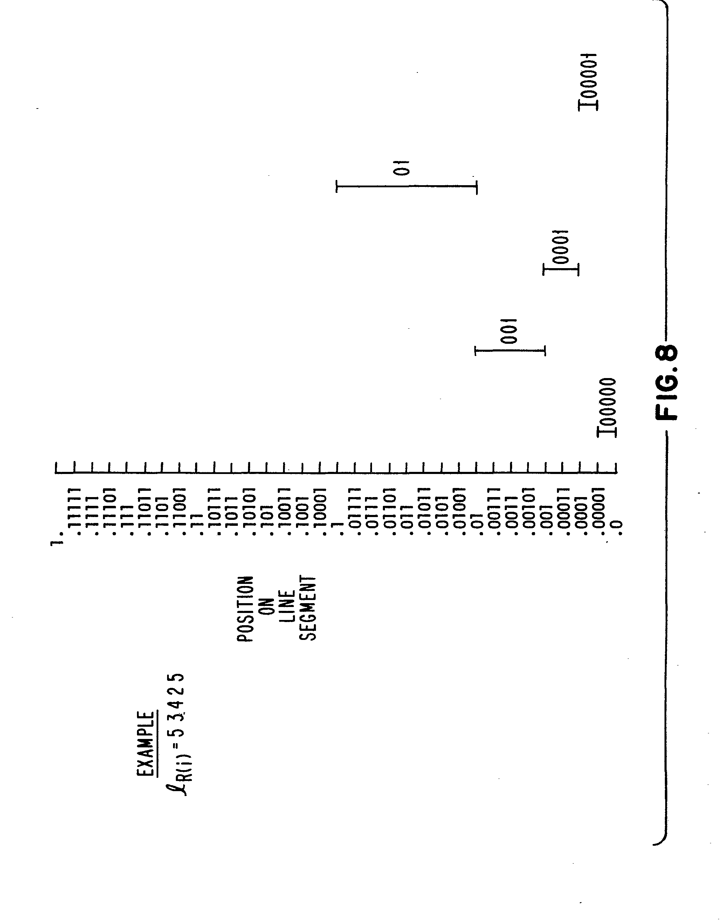

Referring now to Fig. 8, there is shown an example of
consecutive code words of different lengths mapped on to
a line segment of unity length. Relatedly, any position

YO979089

16

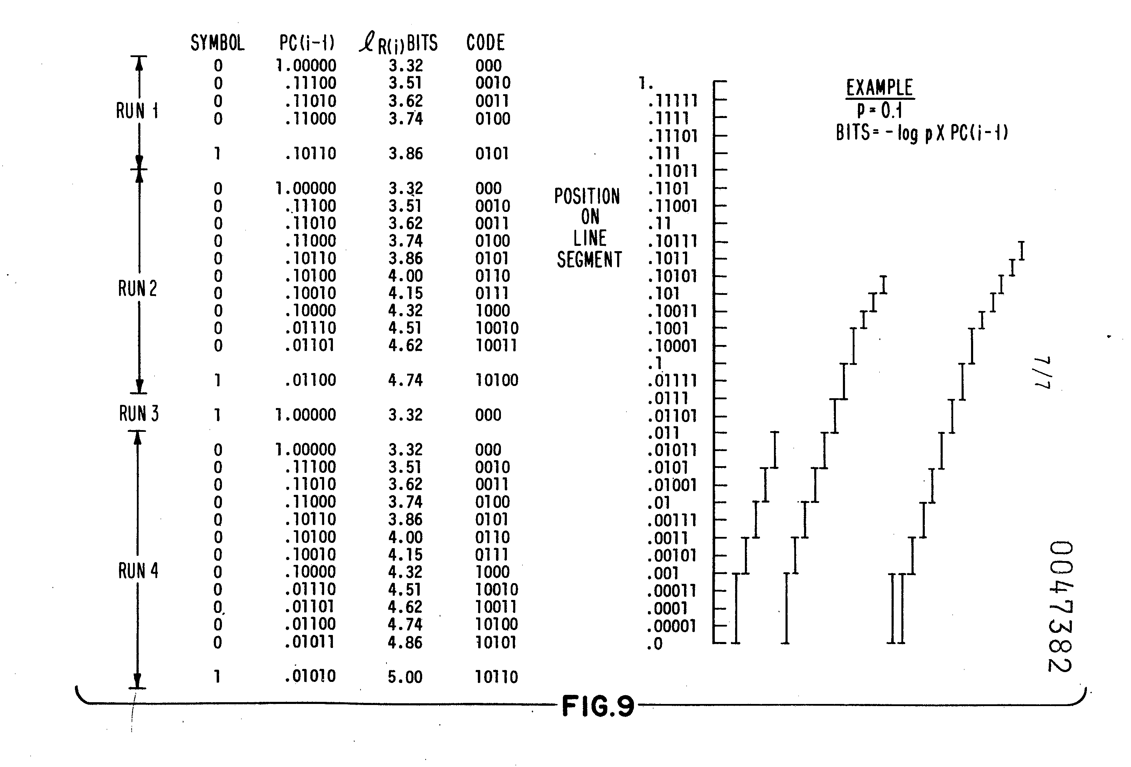

on the line segment is specified in terms of a binary fraction. Further, all points in a segment selected for a code of lengths $\ell_{R(i)}$ must start with the same number of bits. These $\ell_{R(i)}$ bits comprise the code selected. When two or more code words satisfy the above conditions, then the smallest magnitude code word is chosen. This is equivalent to an inverted binary coding tree for which a line segment would be counterpart to a subtree. Likewise, Fig. 9 depicts a set of code words generated in response to a symbol string. The symbol string is set out in the leftmost column and proceeds top to bottom. Counterpart to each symbol is a row entry for the available code space $PC(i-1)$, the code word length attribute $\ell_{R(i)}$, and the prefixed code word. The value $\ell_{R(i)}$ in this table is written prior to rounding. At the start of each symbol string, the available code space is set to unity and the code word length requested is the shortest. With each additional symbol there is a diminution in the available code space, while $\ell_{R(i)}$ increases. Note that the counterpart code words exhibit the prefix property so that as their length increases, no code words can be confused with any other code words. In the Fig. 9 example, 0 is the MPS, while 1 is LPS. Thus, run 1 terminates after four consecutive 0's followed by a 1. At this point, the code space is reset to unity. Run 2 shows a longer run of MPS's. The associated length requests vary between 3 and 5, while the code space exhibits decreasing fractional values. The length requests are rounded. To resolve the integer length code words, they could also have been resolved on the basis of the least integer.

Run 2 terminates in an LPS which is followed by another LPS. Next, run 3 results only in the resetting of a code space and a code word of 000. Run 4, as does run 2 and run 1, generates the same code words for the same run length index i. For example, the fourth symbol in run 1 has the same code word assigned as the fourth symbol in runs 2 and 4.

If the available code space PC contains 12 bits numbered 1 to 12, and the store 9 contains 12 words of 12 bits each, then let word 1 of the store correspond to bit 1 of PC, word 2 to bit 2 of PC, etc. Store 9 has both variable and fixed contents. For word n, bit b is variable if $b<n$. In this case, bit n is forced to 1. In contrast, bit b is 0 if $b>n$.

The relevant store words are those for which the corresponding bits of PC are 1. A store word n is read onto bus 15 if bit n of PC(i-1) is a 1, and bit n of PC(i) is a 0. This is true for one and only one n. An exception occurs when PC(i-1)= 0000 0000 0000, in which case 0000 0000 0000 appears on bus 15.

The contents of bus 15 are written into the store word n if bit n of PC(i-1) is 0 and bit n of PC(i) is 1. This may happen for any number of consecutive words from 0 to 12. It should be apparent that RESET causes PC(i-1) to be 0000 0000 0000.

| i | 1 | 2 | 3 | 4 | 5 |
|---|---|---|---|---|---|
| $\ell_{R(i)}$ | 5 | 3 | 6 | 4 | 5 |
| PC(i-1) | 000000 | 111110 | 110110 | 110101 | 110001 |
| $2^{-\ell R(i)}$ | 1 | 1 | 1 | 1 | 1 |
| PC(i) | 111110 | 110110 | 110101 | 110001 | 101111 |
| ACTION | WWWWW- | --R--- | ----RW | ---R-- | -RWWW- |
| BUS 15 | 000000 | 001000 | 000010 | 000100 | 010000 |
| STORE 1 | ------ | W100000 | →100000 | →100000 | →100000 |
| 9   2 | ------ | W010000 | →010000 | →010000 | →010000 |
| 3 | ------ | W001000 | ------- | ------- | ------- |
| 4 | ------ | W000100 | →000100 | →000100 | ------- |
| 5 | ------ | W000010 | ------- | ------- | ------- |
| 6 | ------ | ------- | ------- | W000011 | →000011 |
| CODE WORD | 00000 | 001 | 000010 | 0001 | 01000 |

Note: $PC(i) = PC(i-1)-2^{-\ell R(i)}$

YO979089

18

Referring now to Table 2, there is shown a sequence of STORE operations. Code words of up to six bits are depicted in the table-based operations. Store words which are not used are indicated by a blank line. Store words for any given operation are depicted at the start of a cycle. Note also that at the beginning of the cycle for i=5, the code space is segmented into blocks as follows:

| length | prefix |
|--------|--------|
| $2^{-1}$ | 1 |
| $2^{-2}$ | 01 |
| $2^{-6}$ | 000011 |

Referring again to Table 2, each of the i cycles is set out as an appropriate column for which a length attribute $\ell_{R(i)}$ has a calculated counterpart. The input into the store over paths 47 and 51 are respectively PC(i) and PC(i-1). These are related according to

$$PC(i) = PC(i-1) - 2^{-\ell}R(i).$$

Starting at the cycle i=1, the available code space is reset. This is manifest by PC(i-1) = 000000. For a length attribute $\ell_{R(i)}=5$, then $2^{-\ell}R(i) = 2^{-5}$. This is a shift to the right by five positions. Since the inputs PC(i) and PC(i-1) to storage 9 by the difference $2^{-\ell}R(i) = 2^{-5}$, then the value PC(i) = 111110 holds. This results in an action of writing into the memory with a counterpart five-bit code word.

During cycle i=2, the old value of PC(i) becomes the new value for PC(i-1). For $\ell_{R(i)}=3$ and $2^{-\ell}R(i)=2^{-3}$ there is a right shift by 3 bit positions, which is

19

dutifully subtracted to form the new value of PC(i). Store 9 contents are explicitly labeled at addresses 1 through 6. The code word appearing on bus 15 is the 3 most significant bits reading from left to right, namely 001.

Starting with the cycle i=3, the code space in the store 9 is altered, by deleting all code words having the prefix 001. For the cycle i=3 for the length attribute $\ell_R=6$, a code word having a 1 in the fifth most significant bit position is placed on the bus. Consequently the code space is diminished by all code words having a 00001 as a prefix.

It is to be understood that the particular embodiment of the invention described above as shown in the drawing is merely illustrative and not restrictive of the broad invention. It provides an alternative to other forms of compression encoding of binary symbol strings, such as described in the co-pending Langdon, et al, application. Whereas FIFO arithmetic codes require the management of carries in their compression stream, the use of prefix codes in this case provides an attractive simple solution for approximating the compression ideal minimum for integer value lengths without any form of carry propagation management. Further, this invention advantageously preserves the partition between the source model and the encoder so as to be operable independent of the adequacy of the model. In the prior art, such failure to preserve the partition significantly limited the circumstances in which a specific compression scheme could be used.

20

The Claims

1. A method for the adaptive compression encoding of a binary source symbol string, the method steps responsive to each source symbol comprise:

    updating a stochastic model indicative of the intersymbol influence among binary source sequences as a function of each applied source symbol;

    generating a most probable symbol from the updated model and a length attribute proportional to the number of most probable symbols in the source symbol string; and

    appending a prefixed code word representation to a code word stream whose code word length is the function of the length attribute upon the occurrence of each least probable symbol.

21

2. A method for appending prefixed code words to a code word stream for storage or transmission purposes, the appending of a code word being conditioned by each least probable symbol in a binary source symbol string, the method steps responsive to each source symbol comprise:

deriving an integer length approximation to the code word required for run length index i of most probable source symbols terminated by a least probable symbol;

dynamically generating a prefixed code word of the derived length from a bounded code word space for each symbol; and

altering the code space either through diminution by an amount proportional to the length of all code words having the same prefix or through resetting to a predetermined initial value, said resetting being conditional either upon the generation of the code word counterpart to each least probable symbol, or upon the space remaining being less than the code word integer length approximation.

3. A method according to claim 1 wherein the step of integer length approximation $\ell_{R(i)}$ is related to the code space $PC(i-1)$ generally available for the run-length index i-1 according to the relation

$$\ell_{R(i)} = \lfloor \log_2 (1/2 + 1/PC(i-1) * p_i(LPS)) \rfloor$$

where $\lfloor .. \rfloor$ denotes the least integer and $p_i(LPS)$ is the relative frequency of the least probable symbol.

YO979089

22

4. A method according to claim 1, wherein the code space $PC(i-1)$ available at the end of run index $i-1$ is governed according to the relation

$$PC(i-1) = 1 - \sum_{j=1}^{i-1} 2^{-\ell}R(j), \text{ where}$$

$\sum 2^{-\ell}R(j)$ is the Kraft sum.

5. A method according to claim 1, wherein the step of altering the code space includes the step of adjusting the remaining code capacity according to the relation

$$PC(1) = PC(i-1) - 2^{-\ell}R(i).$$

6. A method according to claim 1, wherein the integer length $\ell_{R(i)}$ is formed from length descriptors

$$\ell(LPS) + \sum_{j=1}^{i-1} \ell j(MPS).$$

7. In a method for generating variable length prefixed code words responsive to the occurrence of each least probable symbol in a binary source symbol string, the method being executable upon apparatus having a failure-independent stochastic source model and an encoder, wherein the improvements comprise the steps of:

deriving an integer-length approximation $\ell_{R(i)}$ to the code word required for run-length index i of most probable source symbols terminated by a least probable symbol;

dynamically generating a prefixed code word of the derived length from a bounded code word space PC(i-1) for each symbol, $\ell_{R(i)}$ being related to the code space PC(i-1) generally available for the run-length index i-1 according to the relation

$$\ell_{R(i)} = \lfloor \log_2 (1/2 + 1/PC(i-1) * p_i(LPS) \rfloor \text{ where}$$

$\lfloor .. \rfloor$ denotes the least integer and $p_i(LPS)$ is the relative frequency of the least probable symbol; and

altering the code space either through diminution by an amount proportional to the length of all code words having the same prefix or through resetting to a predetermined initial value, said resetting being conditioned either upon the generation of the code word counterpart to each least probable symbol or upon the space remaining being less than the code word integer length approximation.

0047382

1/7

FIG.1

COMPRESSION / DECOMPRESSION SYSTEM

FIG.2

ENCODER BLOCK DIAGRAM

$$\ell_{R(i)} = \ell_i(LPS) + \sum_{j=1}^{i-1} \ell_j(MPS)$$

FIG.3

DECR

FIG.5

0047382

4/7

LIMIT

**FIG.4**

XMIT

**FIG.6**

STORE

**FIG.7**

EXAMPLE

$\ell_{R(i)} = 5\ 3\ 4\ 2\ 5$

POSITION
ON
LINE
SEGMENT

1.
.11111
.1111
.11101
.111
.11011
.1101
.11001
.11
.10111
.1011
.10101
.101
.10011
.1001
.10001
.1
.01111
.0111
.01101
.011
.01011
.0101
.01001
.01
.00111
.0011
.00101
.001
.00011
.0001
.00001
.0

01

001

0001

I00000

I00001

**FIG. 8**

0047382

| | SYMBOL | PC(i-1) | $\ell_{R(i)}$BITS | CODE |
|---|---|---|---|---|
| RUN 1 | 0 | 1.00000 | 3.32 | 000 |
| | 0 | .11100 | 3.51 | 0010 |
| | 0 | .11010 | 3.62 | 0011 |
| | 0 | .11000 | 3.74 | 0100 |
| | 1 | .10110 | 3.86 | 0101 |
| RUN 2 | 0 | 1.00000 | 3.32 | 000 |
| | 0 | .11100 | 3.51 | 0010 |
| | 0 | .11010 | 3.62 | 0011 |
| | 0 | .11000 | 3.74 | 0100 |
| | 0 | .10110 | 3.86 | 0101 |
| | 0 | .10100 | 4.00 | 0110 |
| | 0 | .10010 | 4.15 | 0111 |
| | 0 | .10000 | 4.32 | 1000 |
| | 0 | .01110 | 4.51 | 10010 |
| | 0 | .01101 | 4.62 | 10011 |
| | 1 | .01100 | 4.74 | 10100 |
| RUN 3 | 1 | 1.00000 | 3.32 | 000 |
| RUN 4 | 0 | 1.00000 | 3.32 | 000 |
| | 0 | .11100 | 3.51 | 0010 |
| | 0 | .11010 | 3.62 | 0011 |
| | 0 | .11000 | 3.74 | 0100 |
| | 0 | .10110 | 3.86 | 0101 |
| | 0 | .10100 | 4.00 | 0110 |
| | 0 | .10010 | 4.15 | 0111 |
| | 0 | .10000 | 4.32 | 1000 |
| | 0 | .01110 | 4.51 | 10010 |
| | 0 | .01101 | 4.62 | 10011 |
| | 0 | .01100 | 4.74 | 10100 |
| | 0 | .01011 | 4.86 | 10101 |
| | 1 | .01010 | 5.00 | 10110 |

POSITION ON LINE SEGMENT

1.
.11111
.1111
.11101
.111
.11011
.1101
.11001
.11
.10111
.1011
.10101
.101
.10011
.1001
.10001
.1
.01111
.0111
.01101
.011
.01011
.0101
.01001
.01
.00111
.0011
.00101
.001
.00011
.0001
.00001
.0

EXAMPLE
p = 0.1
BITS = - log p X PC(i-1)

**FIG.9**

0047382